# EUROPÄISCHE PATENTANMELDUNG

(11) **EP 0 733 979 A2**
(43) Veröffentlichungstag der Anmeldung: **25.09.1996**
(21) Anmeldenummer: 96103344.6
(22) Anmeldetag: 04.03.1996
(51) Int. Cl.: G06F 13/14, G06F 9/46, G06F 1/04

(54) **Anordnung zur Umschaltung zwischen mehreren Benutzern zugeordneten Taktsignalen**

(30) Priorität: 24.03.1995 DE 19510800
(71) Anmelder: SIEMENS AKTIENGESELLSCHAFT, 80333 München (DE)
(72) Erfinder: Siebert, Harry, Dipl.-Inform., 82110 Germering (DE)

(57) **Zusammenfassung**

Die Erfindung betrifft eine Anordnung zur Umschaltung zwischen mehreren Benutzern (Ui, Uj) zugeordneten Taktsignalen (Ti, Tj), die wahlweise einer taktgesteuerten Digitalschaltung (DM) zugeführt werden, wobei jedem Benutzer eine Auswahlschaltung (Si) zugeordnet ist der von allen anderen Auswahlschaltungen (Sj) Auswahlkriterien (aj, bj) signalisiert werden. Durch zweistufiges Speichern werden metastabile Zustände und Überschneidungen der erzeugten Aktivitätssignale (acti, actj) vermieden.

## Beschreibung

Die Erfindung betrifft eine Anordnung zur Umschaltung zwischen mehreren Benutzern zugeordneten Taktsignalen, die wahlweise einer taktgesteuerten Digitalschaltung zugeführt werden.

Wenn verschiedene Benutzer auf eine Digitalschaltung, beispielsweise einen First-In- First-Out-Speicher, zugreifen, kommt es häufig wahrend der Umschaltphase zu Problemen. Die Umschaltung auf das andere Taktsignal darf erst erfolgen, wenn das bisher wirksame Taktsignal nicht mehr anliegt.

Aufgabe der Erfindung ist es, eine einfache Anordnung zum Umschalten zwischen unterschiedlichen Taktsignalen, die einer Digitalschaltung zugeführt werden, anzugeben.

Diese Aufgabe wird durch die im unabhängigen Anspruch angegebene Anordnung gelöst.

Vorteilhafte Weiterbildungen sind in den Unteransprüchen angegeben.

Der besondere Vorteil dieser Anordnung ist, daß sie mit wenigen logischen Schaltelementen realisiert werden kann. Durch die verzögerte Abgabe eines Aktivierungssignals kann die Digitalschaltung auch einen oder mehrere zusätzliche Taktimpulse erhalten, um intern erforderliche Arbeitsschritte vornehmen zu können.

Ein Ausführungsbeispiel der Erfindung wird anhand von Figuren näher erläutert.

Es zeigen:
- Figur 1: ein Blockschaltbild mit zwei Benutzern,
- Figur 2: eine Detailschaltung der Anordnung,
- Figur 3: ein Zeitdiagramm und
- Figur 4: eine Variante der Anordnung.

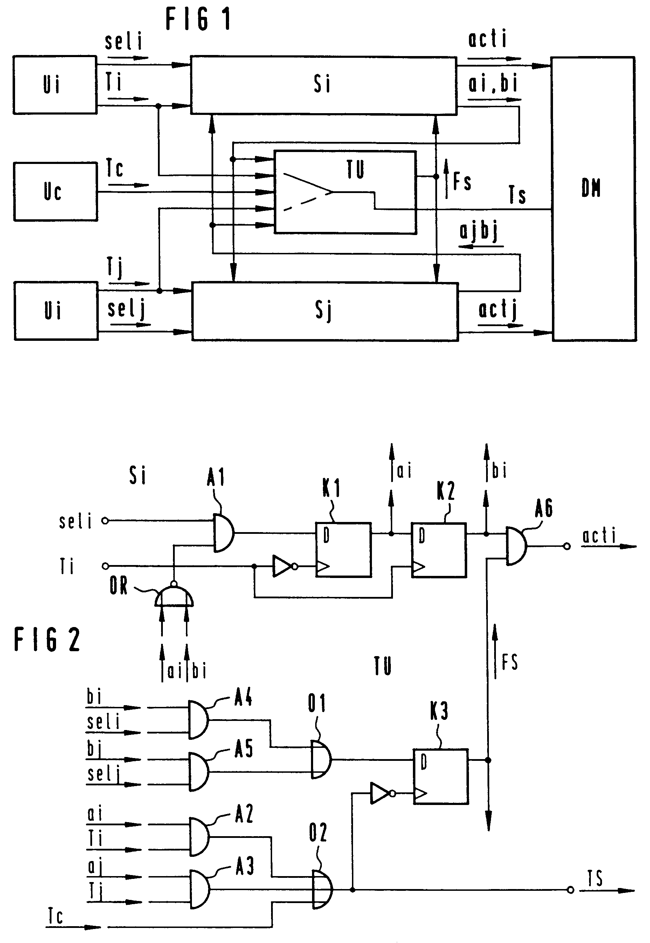

In Figur 1 sind zwei Benutzer Ui und Uj - anstelle von vielen Benutzern - schematisch dargestellt. Jeder Benutzer signalisiert mit einem Auswahlsignal seli bzw. selj den Zugriffswunsch auf eine Digitalschaltung DM, beispielsweise einen Digitalspeicher oder eine arithmetisch-logische Einheit. Der jedem Benutzer zugeordnete Takt Ti bzw. Tj, zu dem die Auswahlsignale nicht synchron sein müssen, wird über eine Taktumschaltung TU geführt, an deren Ausgang das ausgewählte Taktsignal Ts abgegeben und der Digitalschaltung zugeführt wird. In den Auswahlschaltungen Si und Sj werden Aktivitätssignale acti bzw. actj erzeugt, die unterschiedliche Betriebsmoden der Digitalschaltung DM einstellen können. Verfügt die Digitalschaltung nur über einen Aktivierungseingang, können die Aktivierungssignale über eine ODER-Funktion miteinander verknüpft werden. Für eine einwandfreie Funktion ist es wesentlich, daß jede Auswahlschaltung über die Zugriffswünsche der anderen Auswahlschaltungen informiert ist und deshalb ihr Auswahlsignal nur dann wirksam wird, wenn die anderen Auswahlschaltungen dies zulassen.

Über eine Testeinrichtung Uc kann ein Testtaktsignal Tc über die Taktumschaltung TU durchgeschaltet werden, ebenso können auch - nicht dargestellt - Aktivierungssignale simuliert werden.

In Figur 2 sind eine Auswahlschaltung Si und eine Taktumschaltung TU detailliert dargestellt. Alle Auswahlschaltungen Si, Sj, ... sind gleich aufgebaut. Der Auswahlschaltung Si werden von allen anderen Auswahlschaltungen Auswahlkriterien aj und bj über ein NOR-Gatter NOR zugeführt (dessen Eingangsanzahl bei mehr als zwei Benutzern vergrößert werden muß), die über ein erstes UND-Gatter A1 mit dem Auswahlsignal seli des zugeordneten Benutzers Ui zusammengefaßt auf den Dateneingang D einer ersten Kippstufe K1 gelangen, mit der eine zweite Kippstufe K2 in Reihe geschaltet ist. Die Kippstufen K1 und K2 werden von unterschiedlichen Flanken des Taktsignals Ti angesteuert. So ist bei der ersten Kippstufe K1 die negative Flanke des Taktsignals Ti wirksam, die über einen Inverter IN dem Takteingang der Kippstufe zugeführt wird, während bei der zweiten Kippstufen die positive Flanke des Taktsignals Ti wirksam ist.

Wenn nun sämtliche Auswahlkriterien der anderen Auswahlschaltung - hier nur der Auswahlschaltung Sj - signalisieren, daß kein Auswahlsignal vorliegt, d.h. daß sämtliche Eingänge des NOR-Gatters NOR auf der log. Null liegen, dann wird das eigene Auswahlsignal seli über das erste UND-Gatter A1 auf den D-Eingang der ersten Kippstufe durchgeschaltet und blockiert beispielsweise nach der negativen Flanke des zugeordneten Taktsignals Ti als abgetastetes Auswahlkriterium ai bereits eventuelle Auswahlsignale von anderen Benutzern.

Durch die zweite Kippstufe K2 wird ein von metastabilen Zuständen freies verzögertes Auswahlkriterium bi gewonnen. Dieses wird jedoch nicht direkt als Aktivierungssignal acti an die Digitalschaltung DM weitergegeben, sondern über ein sechstes UND-Gatter A6 geführt. Die Übernahme des Ausgangssignales der ersten Kippstufe K1 mit der nächsten (positiven) Flanke des Taktsignals Ti hat den Vorteil, daß die Verzögerung möglichst gering ist.

Geht man davon aus, daß bei der Digitalschaltung dieselben Flanken (beispielsweise die positiven) des Taktsignals Ti wie bei der zweiten Kippstufe wirksam sind, dann sollte das Aktivierungssignal acti jedoch mit einer negativen Flanke ausgegeben werden. Dies erfolgt durch ein Freigabesignal FS der Taktumschaltung.

Die Taktumschaltung enthält eine erste UND-ODER-Schaltung zum Umschalten zwischen den Taktsignalen, die den Benutzern zugeordnet sind, und eine zweite UND-ODER-Schaltung zur Erzeugung eines verzögerten Freigabesignals FS. Die Taktumschaltung erfolgt über UND-Verknüpfungsglieder A2 und A3, denen jeweils abgetastete Auswahlkriterien ai bzw. aj und das zugehörige Taktsignal Ti bzw. Tj zugeführt werden und über ein erstes ODER-Gatter O1, das eines der zugeordneten Taktsignale als Arbeitstaktsignal Ts durchgeschaltet. Wenn die das Auswahlkriterium ai erzeugende erste Kippstufe K1 mit der negativen Flanke des Taktsignals Ti durchgeschaltet wird, ist der nächste positive Impuls des Arbeitstaktsignals bereits zur Ansteuerung der Digitalschaltung wirksam.

An den Eingängen der zweiten UND-ODER-Schaltung A4, A5, O2 wird jeweils ein verzögertes Auswahlkriterium ai und bi mit einem Auswahlsignal seli bzw. selj zusammengefaßt. Der Ausgang des zweiten ODER-Verknüpfungsgliedes O2 ist an den Dateneingang D einer dritten Kippstufe K3 geführt. Liegen zusammengehörige Auswahlsignale und Auswahlkriterien, beispielsweise seli und ai an, dann wird mit der folgenden negativen Taktflanke des ausgewählten Arbeitstaktsignals Ts die dritte Kippstufe K3 gesetzt, die das Freigabesignal FS abgibt.

Erst wenn die Kippstufe K3 eingestellt ist, wird das verzögerte Auswahlkriterium als Aktivitätssignal acti über das sechste UND-Gatter A6 ausgegeben.

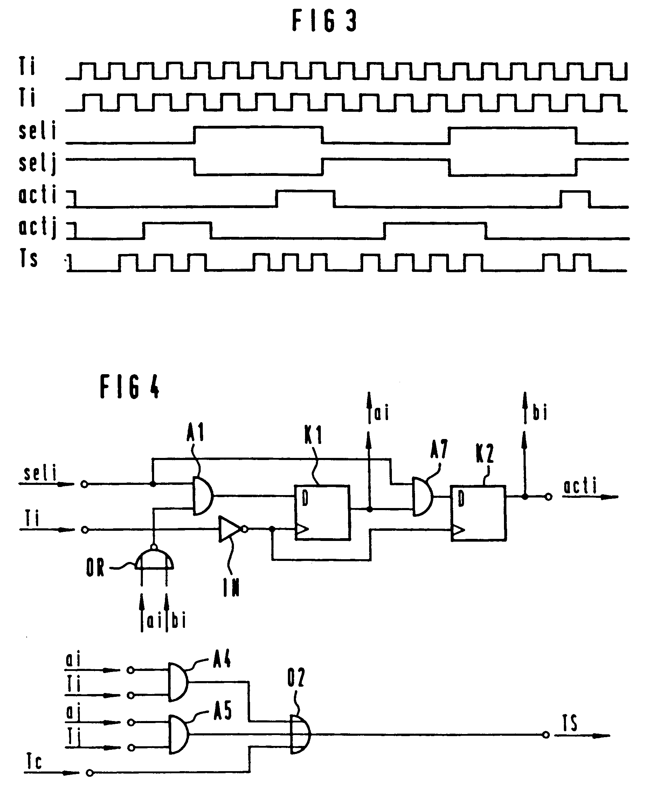

Andererseits wird, sobald das Auswahlsignal seli verschwindet, bereits mit der nächsten negativen Flanke des Arbeitstaktsignals Ts das Aktivitätssignal gesperrt. Das Zeitdiagramm der Figur 3 zeigt die Funktion der Anordnung bei zwei Benutzern unter besonders kritischen Umschaltbedingungen. Die Aktivierungssignale dienen beispielsweise zur Umschaltung zwischen Schreiben und Lesen bei einem Speicher. Vor jedem Aktivierungssignal wird ein zusätzlicher Impuls des neu durchgeschalteten Arbeitstaktsignals erzeugt. Dieser dient zur erforderlichen Neueinstellung der Digitalschaltung. Sollten mehrere dieser Zusatzimpulse erforderlich sein, so können statt der dritten Kippstufe auch mehrere Kippstufen für eine längere Verzögerung verwendet werden; ebenso kann der Zusatzimpuls durch ein A5 entsprechendes Gatter unterdrückt werden.

In Figur 4 ist eine Variante der Schaltung dargestellt, bei der die UND-ODER-Schaltung A1, A2, O1 und die dritte Kippstufe K3 durch jeweils ein siebtes UND-Gatter A7 ersetzt werden, das zwischen dem Ausgang der ersten Kippstufe K1 und dem Dateneingang D der zweiten Kippstufe K2 eingefügt wird und dessen zweitem Eingang ebenfalls das Auswahlsignal seli zugeführt wird. Beiden Kippstufen wird dasselbe invertierte Taktsignal zugeführt. Diese Schaltung ist besonders vorteilhaft, wenn nur ein Zusatzimpuls benötigt wird. Sie weist dieselbe Funktion wie die in Figur 2 dargestellte Schaltung auf.

## Patentansprüche

1. Anordnung zur Umschaltung zwischen mehreren Benutzern (Ui, Uj) zugeordneten Taktsignalen (Ti, Tj), die wahlweise einer taktgesteuerten Digitalschaltung (DM) zugeführt werden,
**dadurch gekennzeichnet,**
daß jedem Benutzer (Ui, Uj) eine Auswahlschaltung (Si, Sj) zugeordnet ist, der ein dem Benutzer zugeordnetes Auswahlsignal (seli, selj) und ein Taktsignal (Ti, Tj) zugeführt werden,
daß in der Auswahlschaltung (Si, Sj) bei Vorliegen des eigenen Auswahlsignals (seli) und bei fehlenden Auswahlkriterien (aj, bj) der anderen Benutzer (Uj) mit Hilfe des zugeordneten Taktsignals (Ti) in einer ersten Kippstufe (K1) ein abgetastetes Auswahlkriterium (ai) und in einer zweiten Kippstufe (K2) ein von diesem abgeleitetes verzögertes Auswahlkriterien (bi) abgespeichert werden, die allen anderen Auswahlschaltungen (Sj, ..) zugeführt werden,
daß das verzögerte Auswahlkriterium (bi) als Aktivitätssignal (acti) der Digitalschaltung (DM) zugeführt wird, und
daß eine Taktumschalteinrichtung (TU) mit einer ersten UND-ODER-Schaltung (A2, A3, O1) vorgesehen ist, deren UND-Verknüpfungsgliedern (A4, A5) von allen Auswahlschaltungen (Si, Sj) jeweils das abgetastete Auswahlkriterium (ai, bi) und das zugehörige Taktsignal (Ti, Tj) werden, daß die UND-Verknüpfungsglieder (A4, A5) über ein erstes ODER-Verknüpfungsglied (O3) zusammengefaßt sind , an dessen Ausgang das ausgewählte Arbeitstaktsignal (Ts) abgegeben wird.

2. Anordnung nach Anspruch 1,
**dadurch gekennzeichnet,**
daß die zweite Kippstufe (K2) mit einer Flanke des Taktsignals (Ti) getriggert wird und die erste Kippstufe (K1) und dritte Kippstufe (K3) mit der anderen Flanke des Taktsignals (Ti) getriggert werden,
daß UND-Verknüpfungsglieder (A2, A3) einer zweiten UND-ODER-Schaltung (A4, A5, O2) jeweils eines der Auswahlsignale (seli, selj) und eines der verzögerten Auswahlkriterien (bi, bj) zugeführt sind, daß die UND-Verknüpfungsglieder (A4, A5) über ein zweites ODER-Verknüpfungsglied (O2) zusammengefaßt sind und auf den Dateneingang (D) einer dritten Kippstufe (K3) geführt sind, die ein Freigabesignal (FS) erzeugt, das über ein Verknüpfungsglied (A7) in jeder Auswahlschaltung (Si, Sj) das verzögerte Aktivitätskriterium (aj, bj) als Aktivitätssignal (acti, actj) an die Digitalschaltung (DM) durchschaltet.

3. Anordnung nach Anspruch 1,
**dadurch gekennzeichnet,**
daß zwischen dem Ausgang (Q) der ersten Kippstufe (K1) und dem Eingang (D) der zweiten Kippstufe (K2) ein weiteres UND-Gatter (A7) eingeschaltet ist, dessen zweitem Eingang das Auswahlsignal (seli) zugeführt wird.

4. Anordnung nach Anspruch 2,
**dadurch gekennzeichnet,**
daß noch mindestens eine weitere Kippstufe der dritten Kippstufe (K3) nachgeschaltet ist, die mit demselben Taktsignal (Ti) angesteuert wird.

5. Anordnung nach einem der vorhergehenden Ansprüche,
**dadurch gekennzeichnet,**
daß als Digitalschaltung (DM) ein Speicher vorgesehen ist, und die Aktivierungssignale (acti, actj) den Schreibbetrieb oder den Lesebetrieb auswählen.

6. Anordnung nach einem der Ansprüche 1 bis 5,
**dadurch gekennzeichnet,**
daß als Digitalschaltung (DM) eine arithmetisch-logische Einheit vorgesehen ist.

7. Anordnung nach einem der vorhergehenden Ansprüche,
**dadurch gekennzeichnet,**
daß die Aktivierungssignale (acti, actj) über ein weiteres ODER-Verknüpfungsglied zusammengefaßt werden bevor sie einem einzigen Aktivierungseingang der Digitalschaltung (DM) zugeführt werden.
